# EUROPÄISCHE PATENTANMELDUNG

(11) **EP 1 187 199 A2**
(43) Veröffentlichungstag der Anmeldung: **13.03.2002**
(21) Anmeldenummer: 01810758.1
(22) Anmeldetag: 03.08.2001
(51) Int. Cl.: H01L 23/367, H01L 21/48

(54) **Kühlkörper für Halbleiterbauelemente, Verfahren zu seiner Herstellung sowie Formwerkzeug dafür**

(30) Priorität: 28.08.2000 DE 10042124; 26.10.2000 DE 10053240
(71) Anmelder: Alcan Technology & Management AG, 8212 Neuhausen am Rheinfall (CH)
(72) Erfinder: Graf, Werner, 78234 Engen (DE); Bock, Uwe, 78224 Singen (DE)

(57) **Zusammenfassung**

Bei einem Kühlkörper (10) aus metallischem Werkstoff -- insbesondere aus einer Leichtmetall-Legierung -- für Halbleiterbauelemente od. dgl. Bauteile finden sich in Abstand (f) etwa parallel zueinander von einer Grundplatte (12) aufragende plattenartige Kühlrippen (20, 20ₑ), die mit einem Sockelstreifen (24) in die Grundplatte einragen, in welche dieser angegossen ist. Ein für die Herstellung dieses Kühlkörpers (10) konzipiertes Formwerkzeug ist als Gießkokille (30) mit einem Formraum für die Grundplatte (12) ausgebildet, und dieser Formraum enthält einen Bereich zur Aufnahme der Sockelstreifen (24) der Kühlrippen (20, 20ₑ). Zwei parallele Seitenwände (34) der Gießkokille (30) sowie zwischen ihnen parallel angeordnete -- jeweils einen Aufnahmespalt (29) begrenzende -- Zwischenlagen (28) sind auf wenigstens einer sie durchsetzenden Welle (19) verschieblich angeordnet und können an dieser zur Herstellung der kompakten Gießkokille (30) -- nach dem Einbringen der Kühlrippen (20, 20ₑ) in die Aufnahmespalte (29) -- verschoben werden.

## Beschreibung

Die Erfindung betrifft einen Kühlkörper aus metallischem Werkstoff -- insbesondere aus einer Leichtmetall-Legierung -- für Halbleiterbauelemente od.dgl. Bauteile, mit in Abstand etwa parallel zueinander von einer Grundplatte aufragenden Kühlrippen etwa stabartigen Querschnittes, die mit einem Sockelstreifen in die Grundplatte einragen. Zudem erfasst die Erfindung ein Verfahren zu dessen Herstellung sowie ein Formwerkzeug dafür.

Die DE 35 18 310 C2 offenbart einen Kühlkörper mit aus einer AlMgSi-Legierung in einer Pressmatrize als Formwerkzeug stranggepresster Grundplatte, in deren Oberfläche Einsatznuten für die aus einem Blech oder einem Profil hergestellten plattenartigen Kühlrippen eingeformt sind. Letztere weisen einen Sockel auf, der nach dem Einsetzen in eine der Nuten durch einen Verstemmprozess verformt werden. Bei sehr kurzem Rippenabstand und hohen Kühlrippen wird hierbei die Belastung eines Verstemm-Meisels so groß, dass er schnell knickt. Bei anderen bekannten Kühlkörpern werden die Kühlrippen eingeklebt bzw. eingelötet. Das Kleben hat den Nachteil, dass der Wärmeübergang von der Basis- oder Grundplatte zur Kühlrippe durch den Kleber verschlechtert wird. Für das Löten wiederum ist eine aufwendige Vorbehandlung erforderlich.

Für einen anderen Kühlkörper wird gemäß DE 25 02 472 C2 die Grundplatte ebenfalls mit Nuten hergestellt, deren Wäünde in ihrer Längsrichtung mit herausgepressten Wandrippen versehen sind. In diese Nuten werden Kühlrippen mit vertikaler Riffelung eingepresst und zwar auf dem Wege des Kaltpressschweißens. Durch die erforderlichen hohen Kräfte, die beim Kaltpressschweißvorgang angewendet werden müssen, ist die Länge der entstehenden Kühlkörper starkt begrenzt, auch ist eine Mindestdicke der Kühlrippen notwendig, um deren Abknicken beim Kaltpressschweißvorgang zu vermeiden.

Doch nicht nur die entstehenden Kräfte begrenzen die Kühlkörperlänge: Durch die vertikale Riffelung der Kühlrippen ist deren entlang der Grundplatte gemessene Länge durch das Maß des Strangpresswerkzeuges begrenzt, da die Pressrichtung gleich der Riffelungsrichtung ist.

In Kenntnis dieses Standes der Technik hat sich der Erfinder das Ziel gesetzt, einen Kühlkörper zu schaffen, der die beschriebenen Mängel nicht aufweist. Zudem soll die Wärmeleitfähigkeit bzw. die Steuerung der Wärmeleitung verbessert werden.

Zur Lösung dieser Aufgabe führt die Lehre des unabhängigen Patentanspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale.

Erfindungsgemäß ist die -- aus Metallwerkstoff bestehende-- Grundplatte an die -- ihrerseits metallischen -- Kühlrippen im Bereich von deren Sockelstreifen angegossen, d.h. nachträgliche Einsetz- und Verformungsvorgänge entfallen. Zudem ermöglicht der Gießvorgang die Integration von Einlegeteilen aus wärmeleitendem Werkstoff zum Erhöhen der Leitfähigkeit sowie zur Steuerung der Wärmeverteilung.

Nach einem weiteren Merkmal der Erfindung soll in die Grundplatte zumindest ein Einlegeteil aus gut wärmeleitendem Werkstoff eingegossen sein; als Einlegeteile können bevorzugt sog. Wärmerohre (heat-pipes) zur Steuerung der Wärmeleitung herangezogen werden.

Günstig sind mehrere Wärmerohre als Einlegeteile, die zueinander und zu Stirnflächen der Grundplatte parallel verlaufen. Zudem sollen sich die Einlegeteile zwischen den parallelen Seitenflächen der Grundplatte erstrecken.

Im Rahmen der Erfindung liegt ein Verfahren zum Herstellen eines solchen Kühlkörpers, bei dem zur Bildung von Kühlrippen plattenartige Formteile in etwa parallelem Abstand zueinander in einer Kokille so angeordnet werden, dass ihre Sockelstreifen vorgegebener Höhe in den Kokillenformraum für die Grundplatte einragen und dieser Formraum mit dem metallischen Werkstoff als Gießmasse gefüllt wird; bei deren Erstarren werden die Sockelstreifen von der Grundplatte haltend erfasst und bilden anschließend mit ihr eine Einheit.

Zur Vereinfachung des Gießvorganges werden durch den Einsatz zueinander paralleler Zwischenlagen Aufnahmespalte für die plattenartigen Formteile hergestellt und letztere in die Aufnahmespalte eingeschoben, wonach zwei zu den Zwischenlagen parallele Seitenwände unter Druck gegeneinander geführt werden, um eine kompakte Form zum Vorbereiten des Gießvorganges entstehen zu lassen.

Nach einem weiteren Merkmal der Erfindung sollen vor dem Einfüllen der heißen Gießmasse Einlegeteile aus wärmeleitendem Werkstoff im Formraum festgelegt werden, um sie in die Grundplatte mit einzugießen.

Als Formwerkzeug dient erfindungsgemäß eine Gießkokille mit einem Formraum für die Basis- oder Grundplatte, welchem vor dem eigentlichen Gießvorgang die aus Blech oder einem Profil erzeugten parallelen Kühlrippen so zugeordnet werden, dass deren Fußkanten samt anschließenden Sockelstreifen in den für die Gießmasse bestimmten Bereich ragen und dort beim Gießvorgang von letzterer erfasst werden; nach dem Erstarren der Gießmasse ist der Kühlkörper dann mit den metallisch innig verbundenen Bestandteilen einsatzbereit.

Im Formwerkzeug sind erfindungsgemäß zwei parallele Seitenwände sowie zwischen ihnen -- ebenfalls parallel angeordnete -- Zwischenlagen auf wenigstens einer sie durchsetzenden Welle verschieblich angebracht; die plattenartigen Formteile werden in die von den Zwischenlagen begrenzten Aufnahmespalte eingeschoben, bis sie an der/den Welle/n anschlagen, dann werden die Seitenwände in Wellenrichtung unter Druck gesetzt, bis eine kompakte Gießform entstanden ist. Deren Formboden wird wesentlich von Fußkanten der Zwischenlagen bestimmt.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:
- Fig. 1:: eine Schrägsicht auf einen Kühlkörper mit von einer Grundplatte aufragenden parallelen Kühlrippen;
- Fig. 2:: eine Draufsicht auf eine Kokille als Vorrichtung zum Herstellen des Kühlkörpers;
- Fig. 3 bis Fig. 5:: jeweils eine Schrägsicht unter die Grundplatte von drei verschiedenen Ausführungsformen des Kühlkörpers;
- Fig. 6:: eine Schrägsicht auf die Kokille zum Herstellen des Kühlkörpers;
- Fig. 7:: einen vergrößerten Ausschnitt aus Fig. 6 in Frontansicht.

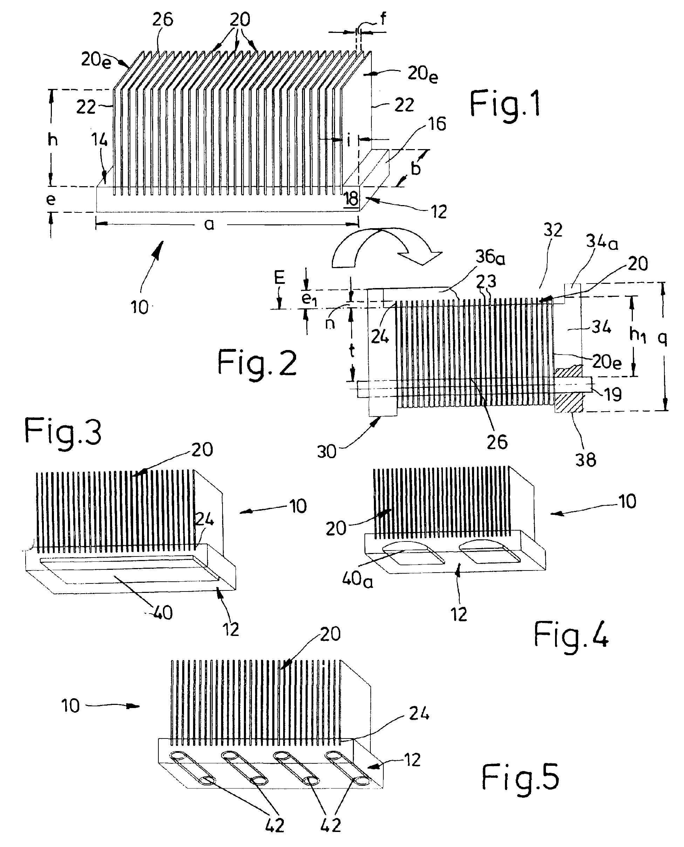

Ein längsschnittlich etwa kammartiger Kühlkörper 10 aus einer Aluminiumlegierung -- beispielsweise einer AlMgSi-Legierung -- für in der Zeichnung aus Gründen der Übersichtlichkeit nicht weiter dargestellte Halbleiterbauelemente weist eine Grundplatte 12 der Länge a, Breite b und Höhe e auf mit von deren Oberfläche 14 in engen Abständen f aufragenden plattenartigen Kühlrippen 20 einer freien Höhe h. Der Abstand zwischen einer die Oberfläche 14 der Grundplatte 12 bestimmenden Ebene E und der in gezeigter Gießstellung oberen Kontur einer in Fig. 2 erkennbaren Welle 19, welche parallel zur Grundplatte 12 verläuft, ist mit t bezeichnet.

Die beiden endwärtigen Kühlrippen 20ₑ verlaufen zu der jeweils benachbarten Stirnfläche 16 der Grundplatte 12 in einem Abstand i, dessen Länge nahezu der Plattenhöhe e entspricht. Die Seitenkanten 22 der Kühlrippen 20, 20ₑ fluchten mit den Seitenflächen 18 der Grundplatte 12.

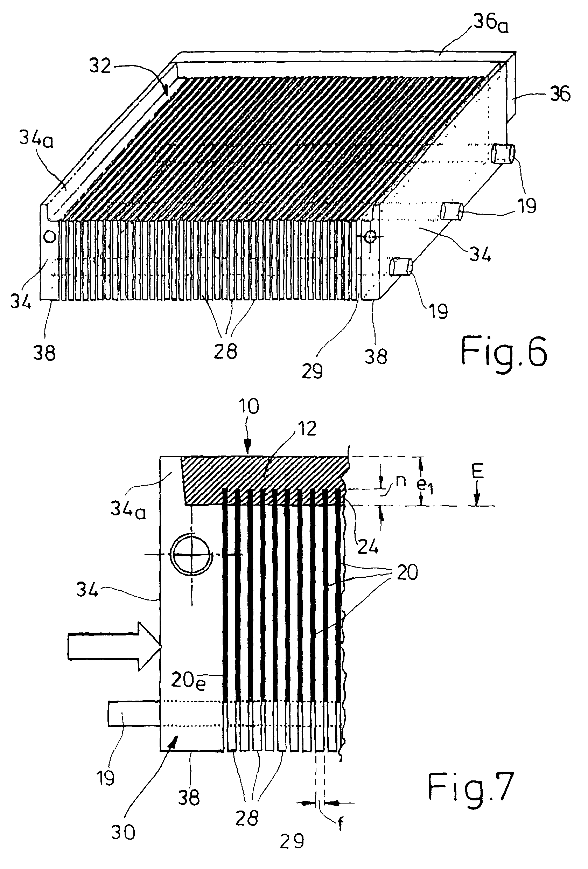

Zum Herstellen des Kühlkörpers 10 werden die aus Blech oder Profilen gefertigten Kühlrippen 20, 20ₑ der Gesamthöhe h₁-- unter Zwischenschaltung von ihren Rippenabstand f bestimmenden Zwischenlagen 28 (s. Fig. 7) -- so in eine Kokille 30 aus Stahl eingelegt, dass jeweils ein -- von der Fußkante 23 der Kühlrippe 20, 20ₑ ausgehender -- kurzer Sockelstreifen 24 der Höhe n in einen Formraum 32 der Kokille 30 ragt, dessen Boden von jener Ebene E bestimmt wird und dessen Höhe e₁ einem Mehrfachen der Höhe n jenes Sockelstreifens 24 entspricht.

Durch Fig. 6, 7 wird besonders deutlich, dass die Kokille 30 zwei Seitenwände 34 und mehrere der zwischen sich Aufnahmespalte 29 der Breite f begrenzenden parallelen Zwischenlagen 28 aufweist, deren Zahl um eine geringer ist als die Zahl der Kühlrippen 20, 20ₑ. Die Seitenwände 34 und die Zwischenlagen 28 lassen sich auf den sie durchsetzenden Wellen 19 verschieben, so dass Dickentoleranzen der Kühlrippen 20, 20ₑ ausgeglichen werden können. Letztere werden -- in Fig. 6, 7 von oben her -- zwischen die Zwischenlagen 28 eingeschoben, bis ihre Firstkanten 26 den Wellen 19 aufliegen. Danach wird die Form oder Kokille 30 in Wellenrichtung -- durch nicht dargestellte Druckmittel-- zusammengepresst, d. h. nach unten hin geschlossen. An den freien Stirnflächen werden Deckplatten 36 als Begrenzungswände angebracht. Durch mit den Seitenwänden 34 und den Stirnwänden oder Deckplatten 36 einstückige Formleisten 34ₐ, 36ₐ ergibt sich die Begrenzung des rundum geschlossenen Kokillenformraums 32 einer Basis- bzw. Grundplattenform, in welchen -- wie gesagt -- die Kühlrippen 20, 20ₑ um jenes Maß n einragen, wohingegen die benachbarten Fußkanten 27 der Zwischenlagen 28 in jener Ebene E verlaufen, also den wesentlichen Teil des Formbodens bilden. Wird nun dieser Formraum 32 ausgegossen, werden die Kühlrippen 20, 20ₑ mit der Basis- bzw. Grundplatte 12 fest verbunden.

Der Kokillenformraum 32 ist im oberen Bereich der Fig. 2 innerhalb der ihn bestimmenden Formleisten 34ₐ, 36ₐ der Kokille 30 zu erkennen. Die Höhe q -- zumindest -- der Seitenwände 34 ist so bemessen, dass diese in der in Fig. 2 skizzierten Gießstellung die Firstkanten 26 der Kühlrippen 20, 20ₑ mit ihren Wandstirnkanten 38 überragen. Durch das Ausgießen des Kokillenformraumes 32 entsteht -- wie besonders in Fig. 7 erkennbar -- die Grundplatte 12 des Ventilkörpers 10, in welche die Kühlrippen 20, 20ₑ mit ihren Fußabschnitten oder Sockelstreifen 24 eingegossen -- und nach dem Erstarren festgelegt -- sind.

Je nach Anordnung der elektronischen Bauteile können vor dem Gießvorgang in den Formraum 32 plattenartige -- flach oder gewölbt ausgebildete -- Teile 40 bzw. 40ₐ aus besonders gut wärmeleitendem Material eingelegt werden, welche die Leitfähigkeit erhöhen bzw. die Wärmeverteilung steuern; diese Einlegeteile 40, 40ₐ werden gemäß Fig. 3, 4 in die Grundplatte 12 eingegossen.

Statt der plattenartigen Einlegeteile 40, 40ₐ können auch sog. Wärmerohre 42 (heat-pipes) zur Steuerung der Wärmeleitung eingelegt werden. In Fig. 5 verlaufen in der Grundplatte 12 Wärmerohre 42 parallel zueinander und zu den Stirnflächen 16 der Grundplatte 12. Sie erstrecken sich -- wie auch jene plattenartigen Einlegeteile 40, 40ₐ -- zwischen den parallelen Seitenflächen 18 der Grundplatte 12.

## Patentansprüche

1. Kühlkörper aus metallischem Werkstoff, insbesondere aus einer Leichtmetall-Legierung, für Halbleiterbauelemente od.dgl. Bauteile, mit in Abstand (f) etwa parallel zueinander von einer Grundplatte (12) aufragenden Kühlrippen (20, 20ₑ) etwa stabartigen Querschnittes, die mit einem Sockelstreifen (24) in die Grundplatte einragen,
**dadurch gekennzeichnet,**
**dass** die Grundplatte (12) an die Sockelstreifen (24) der Kühlrippen (20, 20ₑ) angegossen ist.

2. Kühlkörper nach Anspruch 1, **dadurch gekennzeichnet, dass** in die Grundplatte (12) zumindest ein Einlegeteil (40, 40ₐ; 42) aus gut wärmeleitendem Werkstoff eingegossen ist.

3. Kühlkörper nach Anspruch 2, **dadurch gekennzeichnet, dass** das Einlegeteil ein Wärmerohr (42) ist.

4. Kühlkörper nach Anspruch 2 oder 3, **gekennzeichnet durch** mehrere Wärmerohre (42) als Einlegeteile, die zueinander und zu Stirnflächen (16) der Grundplatte (12) parallel verlaufen.

5. Kühlkörper nach einem der Ansprüche 2 bis 4, **dadurch gekennzeichnet, dass** sich die Einlegeteile (40, 40ₐ; 42) zwischen den parallelen Seitenflächen (18) der Grundplatte (12) erstrecken.

6. Verfahren zum Herstellen eines Kühlkörpers nach einem der Ansprüche 1 bis 5, **dadurch gekennzeichnet, dass** zur Bildung von Kühlrippen (20, 20ₑ) plattenartige Formteile in etwa parallelem Abstand (f) zueinander in einer Kokille (30) so angeordnet werden, dass ihre Sockelstreifen (24) mit zur Höhe (e₁) eines Kokillenformraumes (32) geringerer Höhe (n) in den Kokillenformraum für die Grundplatte (12) einragen und dieser mit dem metallischen Werkstoff als Gießmasse gefüllt wird, bei deren Erstarren die Sockelstreifen von der Grundplatte haltend erfasst werden.

7. Verfahren nach Anspruch 6, **dadurch gekennzeichnet, dass** mit zueinander parallelen Zwischenlagen (28) Aufnahmespalte (29) für die plattenartigen Formteile (20, 20ₑ) hergestellt und diese in die Aufnahmespalte eingeschoben werden, wonach zwei zu den Zwischenlagen parallele Seitenwände (34) unter Druck gegeneinander geführt werden.

8. Verfahren nach Anspruch 6 oder 7, **dadurch gekennzeichnet, dass** vor dem Einfüllen der heißen Gießmasse Einlegeteile (40, 40ₐ; 42) aus wärmeleitendem Werkstoff im Kokillenformraum (32) festgelegt werden.

9. Formwerkzeug zum Herstellen eines Kühlkörpers (10) mit einer Grundplatte (12) und daraus etwa parallel aufragenden Kühlrippe (20, 20ₑ) etwa stabartigen Querschnitts nach einem der Ansprüche 1 bis 5, **dadurch gekennzeichnet, dass** das Formwerkzeug als Gießkokille (30) mit einem Kokillenformraum (32) für die Grundplatte (12) ausgebildet ist und dieser Kokillenformraum einen Bereich zur Aufnahme von Sockelstreifen (24) der Kühlrippen (20, 20ₑ) enthält, dessen Höhe (n) geringer ist als die Höhe (e) des Kokillenformraumes.

10. Formwerkzeug nach Anspruch 9, **dadurch gekennzeichnet, dass** zwei parallele Seitenwände (34) sowie zwischen ihnen parallel angeordnete Zwischenlagen (28) auf wenigstens einer sie durchsetzenden Welle (19) verschieblich angeordnet sind.

11. Formwerkzeug nach Anspruch 10, **dadurch gekennzeichnet, dass** der Boden (E) des Kokillenformraumes (32) im wesentlichen von den Fußkanten (27) der Zwischenlagen (28) gebildet ist.

12. Formwerkzeug nach Anspruch 10 oder 11, **dadurch gekennzeichnet, dass** die Welle/n (19) einen Anschlag für die in von den Zwischenlagen (28) begrenzte Aufnahmespalte (29) eingebrachten Formteile (20, 20ₑ) bildet/bilden, wobei deren Einschubtiefe (t) kürzer ist als ihre Gesamthöhe (h₁).
